# EUROPEAN PATENT APPLICATION

(11) **EP 4 199 063 A1**
(43) Date of publication of application: **21.06.2023**
(21) Application number: 22207113.6
(22) Date of filing: 14.11.2022
(51) Int. Cl.: H01L 21/822, H01L 21/8238, H01L 27/06, H01L 27/092, H01L 29/417, H01L 29/66, H01L 29/775

(54) **STACKED TRANSISTORS WITH REMOVED EPI BARRIER**

(30) Priority: 14.12.2021 US 202117550861
(71) Applicant: Intel Corporation, Santa Clara, CA 95054 (US)
(72) Inventor: ALAAN, Urusa, HILLSBORO, 97124 (US); CLENDENNING, Scott B., Portland, 97225 (US); RADOSAVLJEVIC, Marko, Portland, 97229 (US); RACHMADY, Willy, Beaverton, 97007 (US); DEWEY, Gilbert, Beaverton, 97006 (US); KUMAR, Nitesh, Beaverton, 97006 (US)
(74) Representative: HGF

(57) **Abstract**

Techniques are provided herein to form semiconductor devices having an epi region contact with a high contact area to either or both top and bottom epi regions in a stacked transistor configuration. In one example, two different semiconductor devices include an n-channel device located vertically above a p-channel device (or vice versa). Source or drain regions are adjacent to both ends of the n-channel device and the p-channel device, such that a source or drain region of one device is located vertically over the source or drain region of the other device. A contact structure may be formed that has a greater width when contacting a top surface of the bottom source or drain region than when contacting a side surface of the top source or drain region. The higher contact area on the bottom source or drain region provides a lower contact resistance compared to previous architectures.

## Description

### FIELD OF THE DISCLOSURE

The present disclosure relates to integrated circuits, and more particularly, to the epi region contact formation for gate-all-around (GAA) semiconductor devices.

### BACKGROUND

As integrated circuits continue to scale downward in size, a number of challenges arise. For instance, reducing the size of memory and logic cells or otherwise increasing device density is becoming increasingly more difficult. One possible solution to increase device density is to stack transistor devices in a vertical direction. As a result, providing contacts to the structures of such stacked devices becomes difficult. There are many non-trivial challenges involved with the fabrication of such stacked devices and the fabrication of contacts to the associated device structures.

### BRIEF DESCRIPTION OF THE DRAWINGS

Figure 1 is a cross-sectional view of an example integrated circuit having a semiconductor device with a particular contact structure in the epi region, in accordance with an embodiment of the present disclosure.
Figures 2A - 2L are cross-sectional views that collectively illustrate an example process for forming a semiconductor device having a wide contact in the epi region, in accordance with some embodiments of the present disclosure.
Figure 3 illustrates a cross-section view of a chip package containing one or more semiconductor dies, in accordance with some embodiments of the present disclosure.
Figure 4 is a flowchart of a fabrication process for a semiconductor device with a particular epi contact geometry, in accordance with an embodiment of the present disclosure.
Figure 5 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form gate-all-around (GAA) semiconductor devices having an epi region contact with a high contact area to either or both top and bottom epi regions in a stacked transistor configuration. The techniques can be used in any number of transistor technologies, but are particularly useful in a complementary metal oxide semiconductor (CMOS) stacked transistor configuration (e.g., stacked in a vertical z-direction from the substrate surface). In one such example, a given CMOS cell includes a p-channel device and an n-channel device. The n-channel device and the p-channel device may both be, for example, GAA transistors each having any number of nanoribbons extending in the same direction where the n-channel device is located vertically above the p-channel device (or vice versa). Source or drain regions are adjacent to both ends of the n-channel device and the p-channel device, such that a source or drain region of one device is located vertically over the source or drain region of the other device. A contact structure is provided that has a greater width when contacting a top surface of the bottom source or drain region than when contacting a side surface of the top source or drain region. In some such example embodiments, note that the contact structure includes a continuous body of conductive material that is in direct contact with, or otherwise adjacent to, both the top source or drain region and the bottom source or drain region. In some such cases, the contact structure may include a relatively thin but distinct layer (e.g., one to several monolayers of a metal-containing layer that is distinct from the continuous body) between the continuous body and the top and/or bottom source and drain regions. The higher contact area on the bottom source or drain region provides a more robust ohmic contact with a lower contact resistance compared to previous contact architectures. Numerous variations and embodiments will be apparent in light of this disclosure.

### General Overview

As previously noted above, there remain a number of non-trivial challenges with respect to designing gate-all-around (GAA) semiconductor devices. In the case of stacked nanoribbon transistors, for example, the stacked structures can cause complications for providing electrical contact to the lower structures. For example, source or drain epi regions may be stacked over one another with an insulative barrier layer between them. The barrier layer can be any insulator material, and isolates the upper source or drain region from the lower source or drain region. However, in some configurations where it is desired to contact the lower source or drain epi region, a portion of the barrier region may be etched away using reactive ion etching (RIE) and a contact may be formed within the recess through the barrier region to contact the lower epi region. However, the contact area on the lower epi region is small compared to the total area on top of the epi region which increases the contact resistance and can lead to a non-functioning device. Furthermore, the RIE process bombards a portion of the lower epi region thus further degrading the transistor performance and increasing contact resistance.

Thus, and in accordance with an embodiment of the present disclosure, techniques are provided herein to remove the insulative barrier layer between top and bottom epi regions and replace it with a conductive contact structure that includes a continuous conductive body that extends from the top epi region to the bottom epi region. Because the insulative barrier layer is removed, the continuous conductive body also extends across a much larger portion (e.g., an entire top surface) of the bottom epi region. According to some embodiments, the insulative barrier layer is initially formed to separate the bottom and top epi regions from each other but is later removed using a vapor etch process. In one example, an atomic layer etch (ALE) process is used to remove the barrier layer while maintaining the integrity of all other surrounding structures. According to some embodiments, a metal halide etchant may be used to selectively remove the barrier layer. Such etchants may leave behind a thin layer (e.g., 0.5 to 2 nanometers) over the top surface of the bottom epi region that includes a metal used in the etchant, such as molybdenum (Mo), tungsten (W), vanadium (V), or niobium (Nb). With the insulative barrier removed, a conductive contact structure may be formed over the bottom epi region that has a much greaterwidth over the top surface of the bottom epi region. The thin conductive layer left behind by the vapor etchant may be considered a part of the conductive contact structure, along with the continuous conductive body. In this sense, note that the conductive contact structure directly contacts the top surface of the bottom epi region, whether it be with the continuous conductive body itself or a relatively thin intervening metal-containing layer. According to some embodiments, the conductive contact structure also contacts the top epi region in situations where the epi regions are to be conductively linked. In some other embodiments, an insulative liner protects the top epi region such that the contact only provides electrical contact with the bottom epi region. Although description herein focuses on the use of GAA transistor configurations, the techniques can be applied to other channel configurations as well, such as nanosheet transistors or nanowire transistors.

According to an embodiment, an integrated circuit includes a first semiconductor device having one or more first semiconductor nanoribbons (or other such bodies, such as nanosheets or nanowires or even fins) extending in a first direction between a first source or drain region and a second source or drain region and a second semiconductor device having one or more second semiconductor nanoribbons extending in the first direction between a third source or drain region and a fourth source or drain region. The one or more first semiconductor nanoribbons are spaced vertically from the one or more second semiconductor nanoribbons in a second direction orthogonal to the first direction. The integrated circuit also includes a conductive contact structure adjacent to at least the first semiconductor device. The conductive contact structure contacts a side surface of the first source or drain region and has a first width at the first source or drain region. The conductive contact structure contacts a top surface of the third source or drain region and has a second width between the first source or drain region and the third source or drain region where the second width is greater than the first width. In some cases, the conductive contact structure includes a continuous conductive body that extends from the first source or drain region to the third source or drain region. The continuous body may contact the first and/or third source and drain regions itself, or there may be a relatively thin intervening metal-containing layer (also part of the conductive contact structure), according to some example embodiments.

According to another embodiment, a method of forming an integrated circuit includes forming a multilayer fin having a first section with first material layers alternating with second material layers, the second material layers comprising a semiconductor material suitable for use as a nanoribbon channel, and a second section over the first section and comprising third material layers alternating with fourth material layers, wherein the fourth material layers comprise a semiconductor material suitable for use as a nanoribbon channel; forming an inner spacer structure around ends of the second and fourth material layers; forming a first source or drain region coupled to the ends of the second material layers; forming a blocking layer over the first source or drain region; forming a second source or drain region coupled to the ends of the fourth material layers and over the blocking layer; removing a portion of the second source or drain region and forming a liner over a remaining portion of the second source or drain region; removing the blocking layer; removing the liner; and forming a conductive contact structure that contacts at least a side surface of the second source or drain region and a top surface of the first source or drain region. In some cases, the conductive contact structure includes a continuous conductive body that extends from the second source or drain region to the top surface of the first source or drain region. The continuous body may contact the respective source or drain regions itself, or there may be an relatively thin intervening metal-containing layer (also part of the conductive contact structure), according to some example embodiments.

The techniques are especially suited for use with gate-all-around transistors such as nanowire and nanoribbon and nanosheet transistors, but may also be applicable in some instances to finFET devices (e.g., stacked finFET structures). The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate electrode can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX or EDS); electron energy loss spectroscopy (EELS); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate an epi contact in a stacked transistor configuration with a greater width over the top surface of a bottom epi region compared to a width of the epi contact adjacent to the top epi region. In another example, such tools may indicate the presence of a relatively thin conductive layer between at least the epi contact and the top surface of the bottom epi region. The thin conductive layer may include a metal, such as Mo, W, V, or Nb used during the vapor etch process. Such features will be detectable, for example, by TEM/EELS and/or TEM/EDS.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

### Architectu re

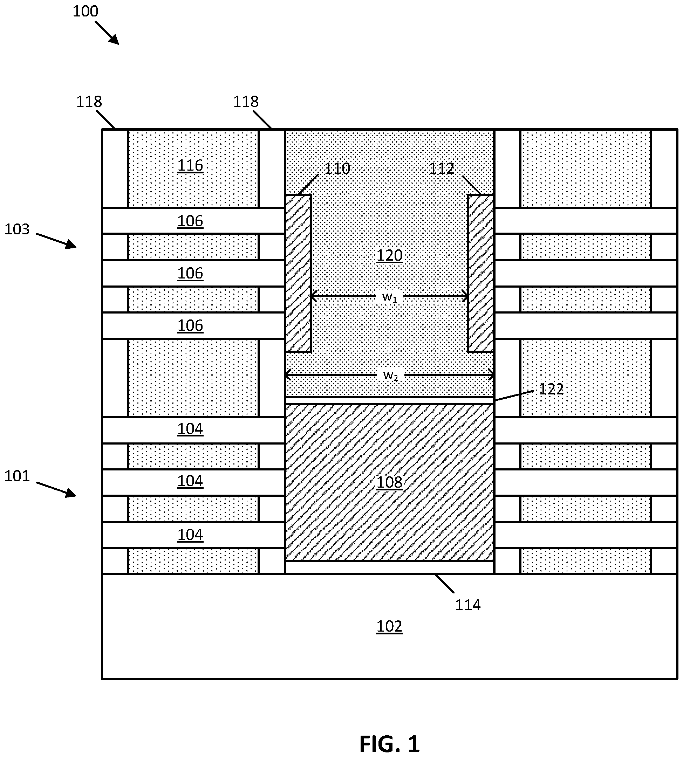

Figure 1 is a cross sectional view of a portion of an integrated circuit 100 that includes a first semiconductor device 101 and a second semiconductor device 103, where second semiconductor device 103 is stacked vertically over first semiconductor device 101, according to an embodiment of the present disclosure. The cross section view is taken lengthwise (perpendicular to gate structure) across first semiconductor device 101 and second semiconductor device 103 in a first direction while the devices are vertically stacked over one another in a second direction substantially orthogonal to the first direction. Each of semiconductor devices 101 and 103 may be gate-all-around (GAA) transistors, although other transistor topologies and types could also benefit from the techniques provided herein. The illustrated embodiments herein use the GAA structure. Semiconductor devices 101 and 103 represent a portion of integrated circuit 100 that may contain any number of similar semiconductor devices. While other semiconductor devices may be illustrated, such as the stacked devices on the right of Figure 1, reference herein is made to the structures of semiconductor devices 101 and 103 for ease of discussion. The description of such structures may apply equally to the corresponding structures of other stacked semiconductor devices in integrated circuit 100.

As can be seen, semiconductor devices 101 and 103 are formed over a substrate 102. Any number of semiconductor devices can be formed in a stacked configuration over substrate 102, but two are discussed here as an example. Substrate 102 can be, for example, a bulk substrate including group IV semiconductor material (such as silicon, germanium, or silicon germanium), group semiconductor material (such as gallium arsenide, indium gallium arsenide, or indium phosphide), and/or any other suitable material upon which transistors can be formed. Alternatively, substrate 102 can be a semiconductor-on-insulator substrate having a desired semiconductor layer over a buried insulator layer (e.g., silicon over silicon dioxide). Alternatively, substrate 102 can be a multilayer substrate or superlattice suitable for forming nanowires or nanoribbons (e.g., alternating layers of silicon and SiGe, or alternating layers indium gallium arsenide and indium phosphide). Any number of substrates can be used.

First semiconductor device 101 may include any number of semiconductor nanoribbons 104 extending between a first source or drain region 108 and a second source or drain region (not illustrated). According to some embodiments, first source or drain region 108 includes an epitaxially grown material that is shared between semiconductor nanoribbons 104 of first semiconductor device 101 and semiconductor nanoribbons of an adjacent semiconductor device.

Second semiconductor device 103 may include any number of semiconductor nanoribbons 106 extending between a third source or drain region 110 and a fourth source or drain region (not illustrated). According to some embodiments, a similar other source or drain region 112 may be present across from third source or drain region 110 in the first direction and coupled to a different semiconductor device. The two source or drain regions 110 and 112 may include a similar doping concentration and be formed during the same epitaxial growth process. Any of the source or drain regions may act as either a source region or a drain region, depending on the application. In some embodiments, semiconductor devices 101 and 103 have an equal number of nanoribbons, while in other embodiments they have an unequal number of nanoribbons. In some embodiments, each of nanoribbons 104 and nanoribbons 106 are formed from a fin of alternating material layers (e.g., alternating layers of silicon and silicon germanium) where sacrificial material layers are removed between nanoribbons 104 and nanoribbons 106. Each of nanoribbons 104 and nanoribbons 106 may include the same semiconductor material as substrate 102, or not. In still other cases, substrate 102 is removed. In some such cases, there may be, for example one or more backside interconnect and/or contact layers. In any such cases, and according to some embodiments, a vertical distance between about 5 nm and about 80 nm separates the nanoribbons 104 of first semiconductor device 101 from the nanoribbons 106 of second semiconductor device 103. Other embodiments may have a smaller or larger such vertical distance.

Any semiconductor materials suitable for source and drain regions can be used (e.g., group IV and group III-V semiconductor materials) for any of the source or drain regions 108, 110, and 112. In any such cases, the composition and doping of the source and drain regions may be the same or different, depending on the polarity of the transistors. In an example, for instance, one transistor is a p-type MOS (PMOS) transistor, and the other transistor is an n-type MOS (NMOS) transistor. Any number of source and drain configurations and materials can be used. In some embodiments, a dielectric layer 114 is present between first source or drain region 108 and substrate 102. Dielectric layer 114 may be any suitable dielectric material, such as silicon oxide, silicon nitride, silicon oxynitride, or silicon oxycarbonitride. In some other embodiments, dielectric layer 114 is not present.

A gate structure 116 is provided over each of nanoribbons 104 and nanoribbons 106 in a shared gate architecture, according to some embodiments. In some other embodiments, a dielectric layer is present between nanoribbons 104 and nanoribbons 106 to produce a split gate architecture where a first gate structure around nanoribbons 104 is electrically isolated from a second gate structure around nanoribbons 106. The embodiments illustrated herein use the shared gate architecture but are equally applicable to split gate architectures.

Spacer structures 118 are included on either side of gate structure 116. Spacer structures 118 may include a dielectric material, such as silicon nitride, silicon oxynitride, or silicon oxycarbonitride. Gate structure 116 includes both a gate dielectric around each of nanoribbons 104 and nanoribbons 106 and a gate electrode over the gate dielectric. The gate dielectric may include a single material layer or multiple material layers. In some embodiments, the gate dielectric includes a first dielectric layer such as an oxide native to nanoribbons 104 and 106 (e.g., silicon oxide) and a second dielectric layer that includes a high-k material (e.g., such as hafnium oxide). The high-k dielectric material may be doped with an element to affect the threshold voltage of the given semiconductor device. In other embodiments, the gate dielectric only includes high-k dielectric material; in still other embodiments, the gate dielectric only includes regular-k dielectric material (e.g., silicon oxide). In some embodiments, the gate dielectric around nanoribbons 104 has a different element doping concentration compared to the gate dielectric around nanoribbons 106. According to some embodiments, the doping element used in the gate dielectric is lanthanum.

According to some embodiments, the gate electrode extends over the gate dielectric around each of nanoribbons 104 and nanoribbons 106 and also generally fills the remaining space between the various nanoribbons of any number of stacked semiconductor devices. The gate electrode may include any sufficiently conductive material such as a metal, metal alloy, or doped polysilicon. In some embodiments, the gate electrode includes one or more workfunction metals around nanoribbons 104 and 106. In some embodiments, semiconductor device 101 is a p-channel device that includes n-type dopants within nanoribbons 104 and includes a workfunction metal having titanium around nanoribbons 104 and semiconductor device 103 is an n-channel device that includes p-type dopants within nanoribbons 106 and includes a workfunction metal having tungsten around nanoribbons 106. N-type dopants may also be used within the nanoribbons of an n-channel device and p-type dopants may be used within the nanoribbons of a p-channel device in order to tune the transistor's threshold voltage. The gate electrode may also include a fill metal or other conductive material around the workfunction metals to provide the whole gate electrode structure. According to some embodiments, the gate structure may be interrupted between any adjacent semiconductor devices in a third direction orthogonal to both the first and second directions by a gate cut structure.

As discussed above, a conductive contact 120 may be formed to provide power or signals to each of first source or drain region 108 and third source or drain region 110. Conductive contact 120 may include any conductive material such as copper (Cu), ruthenium (Ru), tungsten (W), cobalt (Co), titanium (Ti), molybdenum (Mo), or any alloys thereof. According to some embodiments, conductive contact 120 is a continuous body of the conductive material and includes a first width *w₁* adjacent to third source or drain region 110 that is smaller than a second width *w₂* above a top surface of first source or drain region 108. In some examples, the second width *w₂* is substantially the same as the full width of first source or drain region 108. In one embodiment, first width *w₁* may be between about 5 nm and about 30 nm while second width *w₂* may be between about 10 nm and about 40 nm. As observed in Figure 1, conductive contact 120 may have a substantially consistent second width *w₂* between first source or drain region 108 and third source or drain region 110. According to some embodiments, a lower contact resistance results from the increased width *w₂* of conductive contact 120 across the top surface of first source or drain region 108.

According to some embodiments, a conductive layer 122 may be present between conductive contact 120 and first source or drain region 108. In this sense, the overall contact structure may include multiple components, including the continuous body of conductive contact 120 and conductive layer 122. Conductive layer 122 may include a different material composition compared to conductive contact 120. In some examples, conductive layer 122 may include any of Mo, W, V, or Nb. Conductive layer 122 may include a silicide or germanide of any of the aforementioned metals. According to some embodiments, conductive layer 122 may be formed as a byproduct of the fabrication process used to remove a barrier layer between first source or drain region 108 and third source or drain region 110. In some embodiments, some metal residue (e.g., residues of any of Mo, W, V, or Nb) may also be present along a portion of the sidewall of spacer structure 118 between nanoribbons 104 and nanoribbons 106. The metal residue on the sidewalls may be non-conductive, according to some embodiments. Since conductive layer 122 also acts as a conductor, the conductive contact may be considered to be a combination of conductive layer 122 and conductive contact 120. In other words, conductive layer 122 may be considered a part of conductive contact 120.

Due to some possible fabrication effects when forming the source/drain trench region, width *w₂* of conductive contact 120 may not necessarily be greater than width *w₁* of conductive contact 120. However, in such situations, conductive contact 120 should still directly contact an entire top surface of first source or drain region 108. According to some embodiments, some dielectric material left over from a dielectric layer previously existing between first source or drain region 108 and third source or drain region 110 may be present within the bottom corners between conductive contact 120 and first source or drain region 108.

### Fabrication Methodology

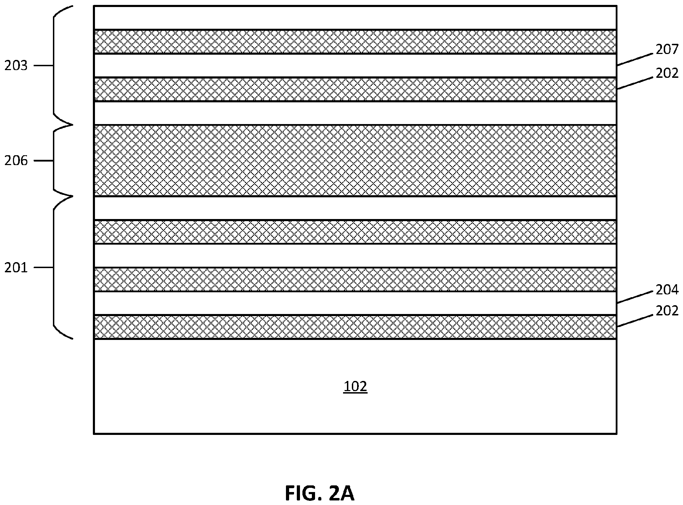

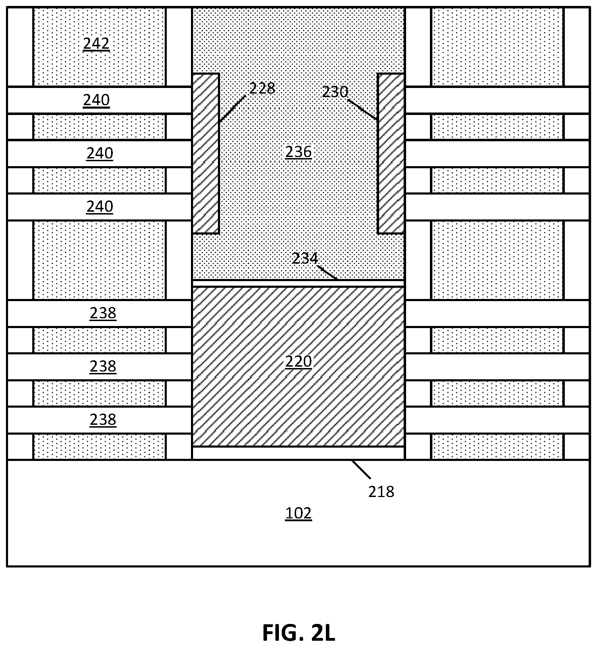

Figures 2A - 2L include cross-sectional views that collectively illustrate an example process for forming an integrated circuit configured with stacked semiconductor devices having a wide contact structure on the bottom epi region. Each figure shows an example structure that results from the process flow up to that point in time, so the depicted structure evolves as the process flow continues, culminating in the structure shown in Figure 2L, which is similar to the structure illustrated in Figure 1. The illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figure 2A illustrates a cross-sectional view across a substrate having a series of material layers deposited over it, according to an embodiment of the present disclosure. The previous relevant discussion with respect to example configurations and materials for substrate 102 is equally applicable here. Alternating material layers may be deposited over substrate 102, including a first layer stack 201, a second layer stack 203, and a spacer layer 206 between first layer stack 201 and second layer stack 203. Each of first and second layer stacks 201 and 203 includes sacrificial layers 202 alternating with other material layers, such as first semiconductor layers 204 of first layer stack 201 and second semiconductor layers 207 of second layer stack 203. Any number of alternating sacrificial layers 202 and material layers may be deposited within each of first layer stack 201 and second layer stack 203. It should be noted that the cross section illustrated in Figure 2A is taken along the length of a fin formed from the multiple alternating layers and extending up above the surface of substrate 102.

According to some embodiments, sacrificial layers 202 have a different material composition than each of first semiconductor layers 204 and second semiconductor layers 207. In some embodiments, sacrificial layers 202 are silicon germanium (SiGe) while each of first semiconductor layers 204 and second semiconductor layers 207 include a semiconductor material suitable for use as a nanoribbon such as silicon (Si), SiGe, germanium, or materials like indium phosphide (InP) or gallium arsenide (GaAs). In examples where SiGe is used in each of sacrificial layers 202 and first and second semiconductor layers 204 and 207, the germanium concentration can be different between sacrificial layers 202 and first and second semiconductor layers 204 and 207. For example, sacrificial layers 202 may include a higher germanium content compared to first and second semiconductor layers 204 and 207. Spacer layer 206 may include the same material as sacrificial layers 202. In some examples, spacer layer 206 can be any material that exhibits a high etch selectivity with the material of semiconductor layers 204 and 207.

While dimensions can vary from one example embodiment to the next, the thickness of each sacrificial layer 202 may be between about 5 nm and about 20 nm. In some embodiments, the thickness of each sacrificial layer 202 is substantially the same (e.g., within 1-2 nm) across each of first layer stack 201 and second layer stack 203. The thickness of each of first semiconductor layers 204 and second semiconductor layers 207 may be about the same as the thickness of each sacrificial layer 202 (e.g., about 5-20 nm). However, according to some embodiments, the thickness of spacer layer 206 is thicker than any of sacrificial layers 202. Spacer layer 206 is provided to create a sufficient spacing between the adjacent semiconductor devices to be formed from first semiconductor layers 204 and second semiconductor layers 207. While dimensions can vary from one example embodiment to the next, the thickness of spacer layer 206 may be between about 10 nm to about 80 nm. Each of sacrificial layers 202, first semiconductor layers 204, spacer layer 206, and second semiconductor layers 207 may be deposited using any known material deposition technique, such as chemical vapor deposition (CVD), plasma-enhanced chemical vapor deposition (PECVD), physical vapor deposition (PVD), or atomic layer deposition (ALD).

First semiconductor layers 204 may be doped with either n-type dopants (to produce a p-channel transistor) or p-type dopants (to produce an n-channel transistor). Similarly, second semiconductor layers 207 may be doped with either n-type dopants (to produce a p-channel transistor) or p-type dopants (to produce an n-channel transistor). In some embodiments, first semiconductor layers 204 and second semiconductor layers 207 are both undoped.

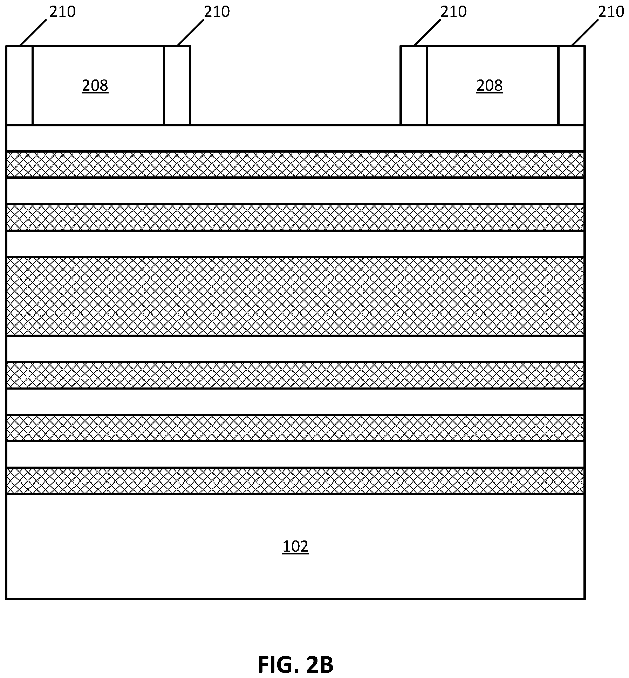

Figure 2B illustrates a cross-sectional view of the structure shown in Figure 2A following the formation of a sacrificial gate structures 208 and sidewall spacers 210 over the alternating layer structure of the fin, according to an embodiment. Sacrificial gate structures 208 may run in an orthogonal direction to the length of the fin and may include any material that can be safely removed later in the process without etching or otherwise damaging any portions of the fin or of spacer structures 210. In some embodiments, sacrificial gate structures 208 include any of polysilicon, amorphous silicon, metals, or hard mask materials like dielectrics. Spacer structures 210 may be formed using an etch-back process where spacer material is deposited everywhere and then anisotropically etched to leave the material only on sidewalls of structures including sacrificial gate structures 208. Spacer structures 210 may include a dielectric material, such as silicon nitride, silicon oxy-nitride, or any formulation of those layers incorporating carbon or boron dopants. Each sacrificial gate structure 208 together with its associated spacer structures 210 define a portion of the fin that will be used to form a stack of transistor devices as discussed further herein.

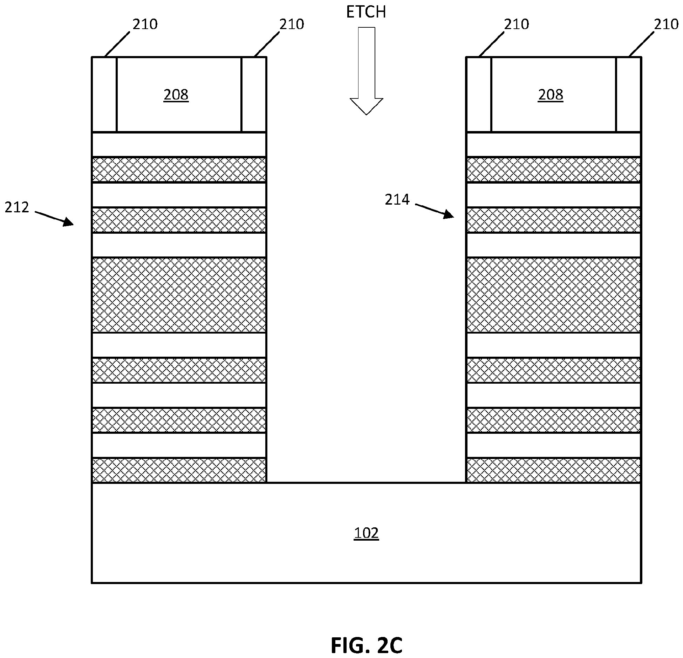

Figure 2C illustrates a cross-sectional view of the structure shown in Figure 2B following the removal of the exposed fin not under sacrificial gate structures 208 and sidewall spacers 210, according to an embodiment of the present disclosure. According to some embodiments, the various layers of the different layer stacks are etched at substantially the same rate using an anisotropic RIE process. As observed in Figure 2C, the width of spacer structures 210 works to define the length of the resulting fins 212 and 214. In some embodiments, some undercutting occurs along the edges of the fins beneath spacer structures 210 such that the lengths of the fins are not exactly the same as a sum of the widths of spacer structures 210 and a width of a given sacrificial gate structure 208. The RIE process may also etch into substrate 102 thus recessing portions of substrate 102 on either side of a given fin 212 or 214. Similar to the discussion related to Figure 1, the discussion of the fabrication process herein will focus on fin 212 though the same processes may be occurring with fin 214.

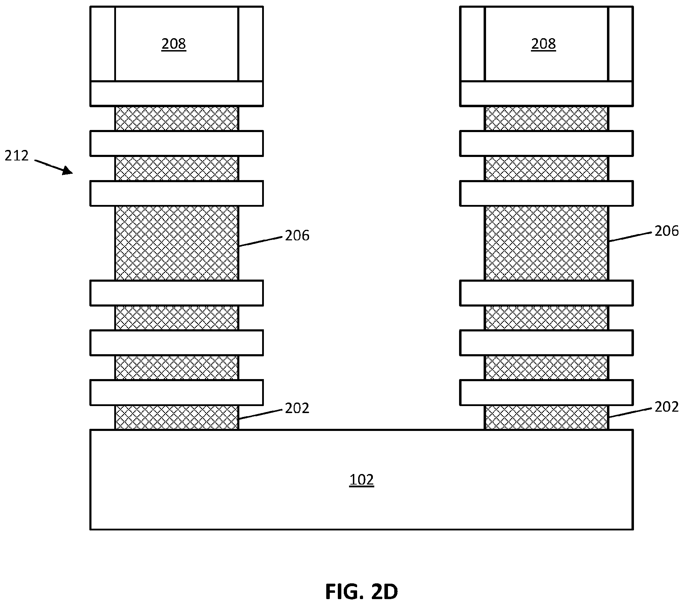

Figure 2D illustrates a cross-sectional view of the structure shown in Figure 2C following the removal of portions of sacrificial layers 202, according to an embodiment of the present disclosure. An isotropic etching process may be used to recess the exposed ends of each sacrificial layer 202 along the entire layer stack of fin 212. Spacer layer 206 may be recessed as well along with each sacrificial layer 202. The isotropic etchant used exhibits a high etch selectivity between sacrificial layers 202 and each of the semiconductor layers.

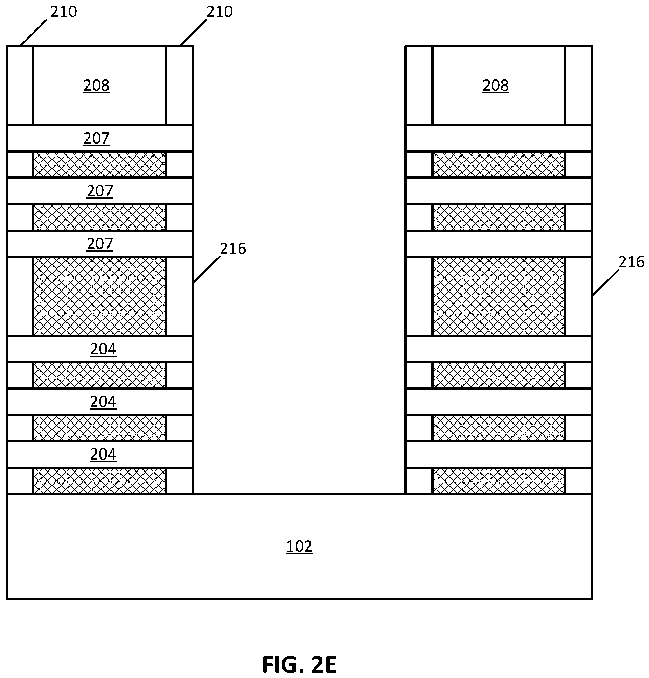

Figure 2E illustrates a cross-sectional view of the structure shown in Figure 2D following the formation of internal spacers 216, according to an embodiment of the present disclosure. Internal spacers 216 may have a material composition that is similar to or the exact same as spacer structures 210. Accordingly, internal spacers 216 may be any suitable dielectric material that exhibits high etch selectively to semiconductor materials such as silicon and/or silicon germanium. Internal spacers 216 may be conformally deposited over the sides of the fin structure using a conformal process like ALD, CVD, or some other type of selective deposition technique. After the dielectric material has been deposited, an isotropic etching process is performed to remove internal spacers 216 from the tips of the semiconductor layers 204 and 207. According to some embodiments, internal spacers 216 are recessed and/or etched inwards at least until the ends of both first semiconductor layers 204 and second semiconductor layers 207 are exposed.

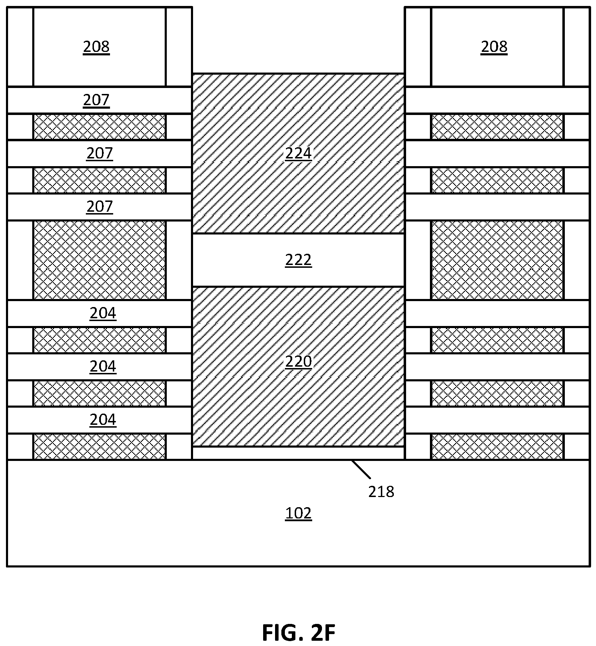

Figure 2F illustrates a cross-sectional view of the structure shown in Figure 2E following the formation of source and drain regions, according to an embodiment of the present disclosure. Due to the vertically stacked spacing between first semiconductor layers 204 and second semiconductor layers 207, a similarly stacked formation of source and drain regions is created. According to an embodiment, a bottom insulator layer 218 is first formed over substrate 102 to isolate the epitaxial source or drain regions from substrate 102. Accordingly, bottom insulator layer 218 may be any suitable dielectric material.

A first source or drain region 220 is formed adjacent to the ends of first semiconductor layers 204. According to some embodiments, at least a portion of first source or drain region 220 is epitaxially grown outward from the exposed ends of first semiconductor layers 204 and the other semiconductor layers across from them. In some embodiments, first source or drain region 220 includes an epitaxial fill of highly doped semiconductor material.

According to some embodiments, an insulator layer 222 is formed over first source or drain region 220 to provide electrical insulation between stacked epitaxial regions. Insulator layer 222 may be any suitable dielectric material, although in some embodiments insulator layer 222 is a titanium-based dielectric. Insulator layer 222 may have a thickness between about 5 nm and about 80 nm.

As noted above, first semiconductor layers 204 extend between first source or drain region 220 and a second source or drain region that would be present on the left side of first semiconductor layers 204. A third source or drain region 224 may be formed above insulator layer 222 and adjacent to the ends of second semiconductor layers 207, such that second semiconductor layers 207 extend between third source or drain region 224 and a fourth source or drain region that would be present on the left side of second semiconductor layers 207. According to some embodiments, at least a portion of third source or drain region 224 is epitaxially grown outward from the exposed ends of second semiconductor layers 207 and the other semiconductor layers across from them. In some embodiments, third source or drain region 224 includes an epitaxial fill of highly doped semiconductor material.

Any semiconductor materials suitable for a doped source or drain region can be used for each of first source or drain region 220 and third source or drain region 224 (e.g., group IV and group semiconductor materials). In any such cases, the composition and doping of source and drain regions 220/224 may be the same or different, depending on the polarity of the transistors. In one example, first semiconductor layers 204 are doped with n-type dopants and first source or drain region 220 includes a high concentration of p-type dopants (PMOS transistor). Similarly, second semiconductor layers 207 may be doped with p-type dopants and third source or drain region 224 includes a high concentration of n-type dopants (NMOS transistor). Any number of source and drain configurations and materials can be used.

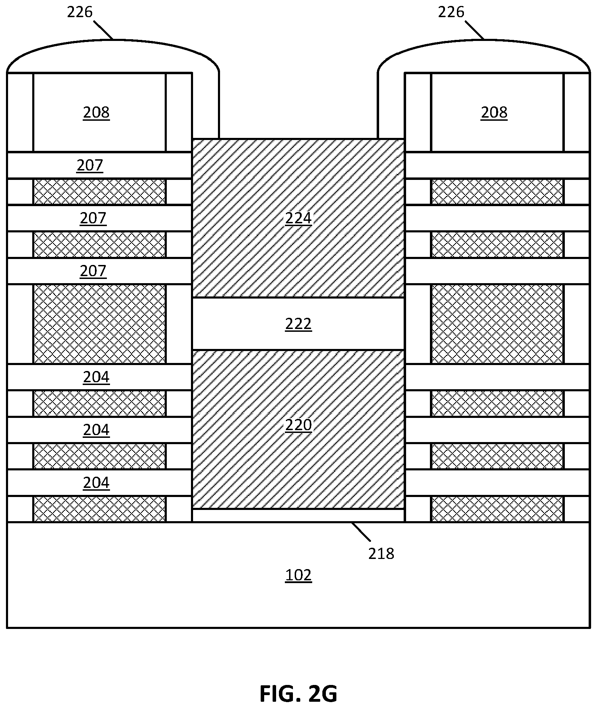

Figure 2G illustrates a cross-sectional view of the structure shown in Figure 2F following the formation of helmet structures, according to an embodiment. Helmet structures 226 may be deposited over the fins using a PVD (e.g., sputtering) and/or ALD process to ensure that helmet structures 226 have a suitable thickness on a top surface of sacrificial gate structure 208 and also along a sidewall portion of spacer structures 210 above third source or drain region 224. According to some embodiments, an anisotropic etch may be performed to remove any portion of helmet structures 226 deposited on the top surface of third source or drain region 224. In some embodiments, the PVD process causes helmet structures 226 to deposit primarily on the top of sacrificial gate structure 208 and side surfaces of spacer structures 210 while not reaching low enough between the semiconductor structures to deposit on the top surface of third source or drain region 224. Helmet structures 226 may be a dielectric material or any wet-etchable material such as titanium nitride or aluminum-based dielectric.

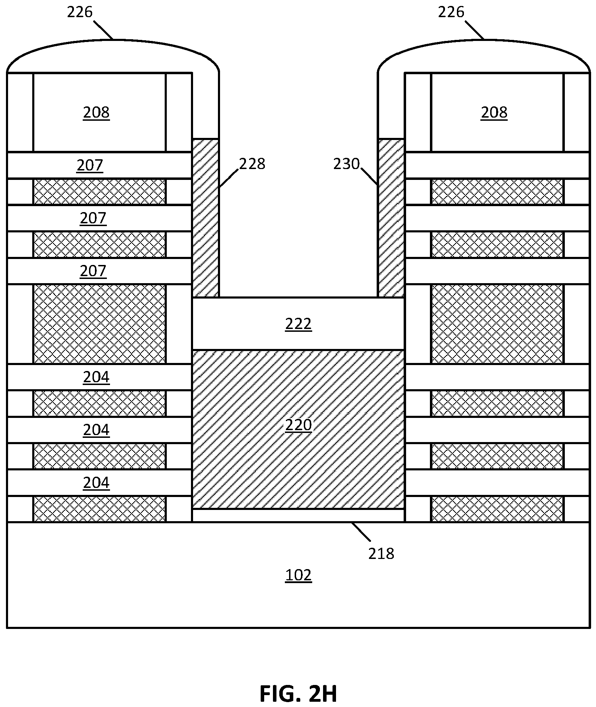

Figure 2H illustrates a cross-sectional view of the structure shown in Figure 2G following the removal of a portion of third source or drain region 224, according to an embodiment. An anisotropic etching process, such as RIE, may be used to remove the middle portion of third source or drain region 224 that is unprotected by helmet structures 226. The etching process effectively splits third source or drain region 224 into two portions with a first portion 228 acting as the third source or drain region for second semiconductor layers 207 and a second portion 230 acting as a source or drain region for an adjacent semiconductor device. For ease of discussion, portion 228 will herein be referred to as the third source or drain region. According to some embodiments, third source or drain region 228 may have a lateral thickness between about 2 nm and about 8 nm.

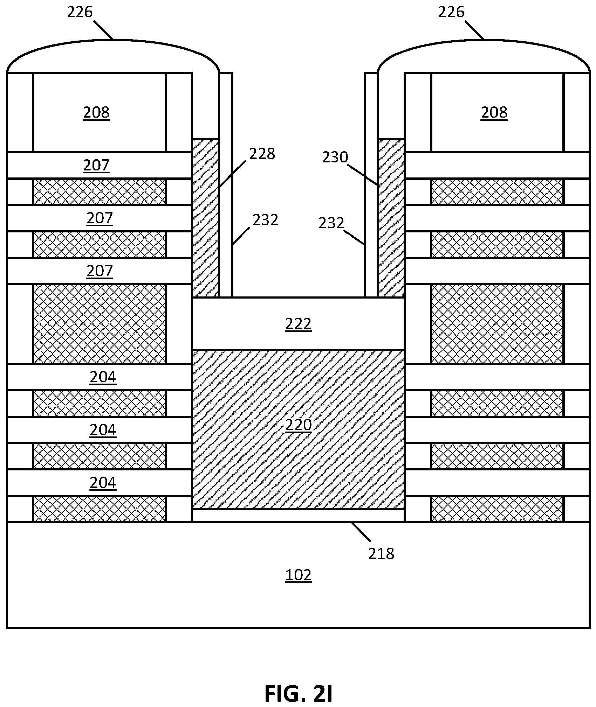

Figure 2I illustrates a cross-sectional view of the structure shown in Figure 2H following the formation of a liner 232 over a sidewall of at least third source or drain region 228, according to an embodiment. Liner 232 may be conformally deposited and then etched back using an anisotropic etching process to leave liner 232 along the sidewalls of third source or drain region 228 and source or drain region 230. According to some embodiments, a portion of liner 232 is also formed over a sidewall portion of helmet structures 226. The etch-back process removes liner 232 from a top surface of insulator layer 222. Accordingly, the top surface of insulator layer 222 may be exposed between liner 232 formed along the sidewalls of third source or drain region 228 and source or drain region 230. According to some embodiments, liner 232 includes a dielectric material that is different from the dielectric material of insulator layer 222. Liner 232 may have a lateral thickness between about 1 nm and about 4 nm.

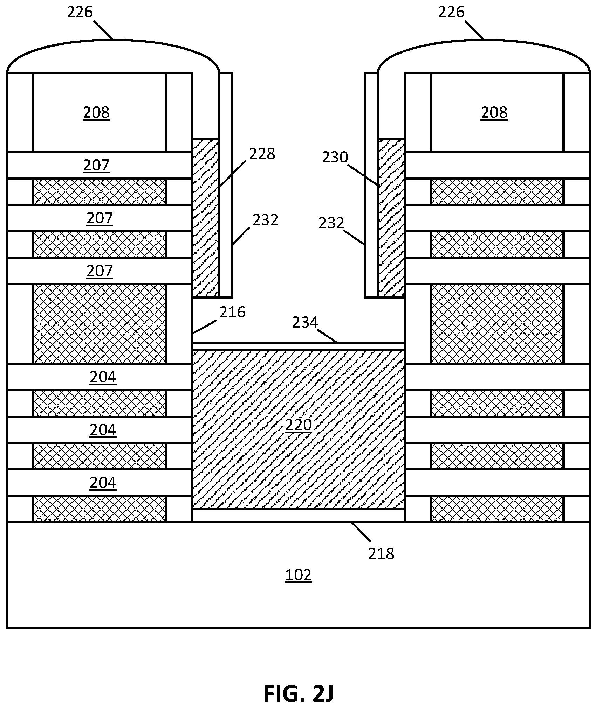

Figure 2J illustrates a cross-sectional view of the structure shown in Figure 2I following the removal of insulator layer 222, according to an embodiment. Insulator layer 222 may be entirely removed, in some embodiments. A vapor phase atomic layer etching (ALE) process may be used to remove an entirety (or nearly all, such as more than 95%) of insulator layer 222. For example, insulator layer 222 may be exposed to a vapor containing a metal halide etchant at a temperature between about 100 °C and about 400 °C. Some examples of metal halides include MoCl₅, MoF₆, WF₆, WCl₆, VF₅, or NbF₅. The etching process may use either a continuous or pulsed exposure to the metal chloride or fluoride vapor. In the case of pulsed exposure, an alternating exposure profile may be used. For example, an oxidizing agent such as O₂, H₂O₂, or O₃ may be introduced followed by a purge and then introduction of the metal halide etchant followed by another purge, which repeats any number of times in an atomic layer etch sequence.

According to some embodiments, the ALE process leaves behind a conductive layer 234 along at least the top surface of first source or drain region 220. Conductive layer 234 may include a metal used in the metal halide etchant, such as Mo, W, V, or Nb. According to some embodiments, conductive layer 234 is a silicide or germanide of any of the aforementioned metals. Conductive layer 234 may have a thickness between about 0.5 nm and about 2 nm. As noted above, residues of the metal present within conductive layer 234 may also be found on the sidewall of internal spacers 216 between first semiconductor layers 204 and second semiconductor layers 207.

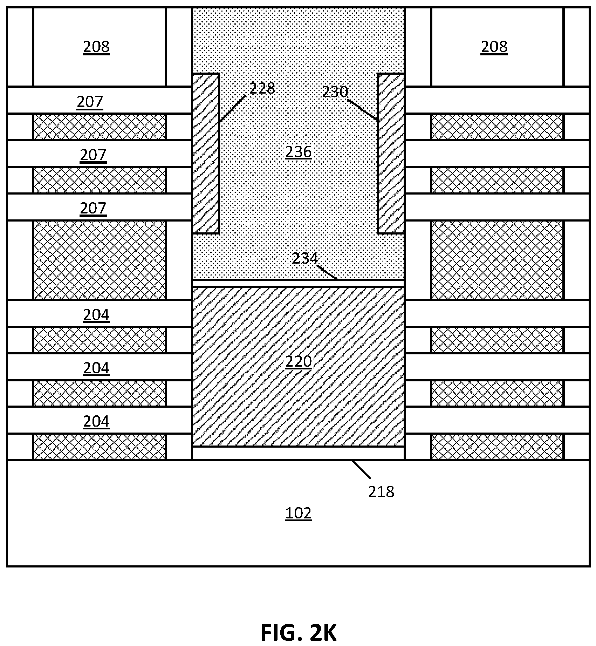

Figure 2K illustrates a cross-sectional view of the structure shown in Figure 2J following the formation of a conductive contact 236, according to an embodiment. Conductive contact 236 may have a polished top surface that is planarized using, for example, chemical mechanical polishing (CMP). Conductive contact 236 may be a continuous body that include any suitable conductive material, such as Cu, Ru, W, Co, Ti, Mo, or any alloys thereof. Since insulator layer 222 was removed, conductive contact 236 has a greater width when contacting first source or drain region 220. For example, conductive contact 236 has a greater width when contacting first source or drain region 220 compared to its width when contacting third source or drain region 228. As discussed above, conductive layer 234 may be considered to be a part of the overall contact structure that further includes conductive contact 236, such that the two materials together form the conductive contact structure that contacts both a top surface of first source or drain region 220 and a side surface of third source or drain region 228.

According to some embodiments, helmet structures 226 and liner 232 have been removed using any wet or vapor isotropic etchants. In some other embodiments, a portion of liner 232 may remain over the sidewall of third source or drain region 228.

Figure 2L illustrates a cross-sectional view of the structure shown in Figure 2K following the removal of the sacrificial gate structure 208 and sacrificial layers 202 and the formation of a gate structure 242, according to an embodiment of the present disclosure. Sacrificial gate structure 208 may be removed using any wet or dry isotropic process thus exposing the alternating layer stack of the fin within the trench left behind after the removal of sacrificial gate structure 208. Once sacrificial gate structure 208 has been removed, sacrificial layers 202 may also be removed using a selective isotropic etching process that removes the material of sacrificial layers 202 but does not remove (or removes very little of) first semiconductor layers 204 and second semiconductor layers 207. At this point, the suspended (sometimes called released) first semiconductor layers 204 form first nanoribbons 238 that extend between first source or drain region 220 and a second source or drain region, and the suspended second semiconductor layers 207 form second nanoribbons 240 that extend between third source or drain region 228 and a fourth source or drain region.

As noted above, gate structure 242 includes a gate dielectric and a gate electrode. The gate dielectric may be conformally deposited around first nanoribbons 238 and second nanoribbons 240 using any suitable deposition process, such as ALD. The gate dielectric may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, molybdenum nitride, niobium nitride, and lead zinc niobate, to provide some examples. According to some embodiments, the gate dielectric is hafnium oxide with a thickness between about 1 nm and about 5 nm. In some embodiments, the gate dielectric may include one or more silicates (e.g., titanium silicate, tungsten silicate, niobium silicate, and silicates of other transition metals). The gate dielectric may be a multilayer structure, in some examples. For instance, the gate dielectric may include a first layer on first and second nanoribbons 238/240, and a second layer on the first layer. The first layer can be, for instance, an oxide of the semiconductor layers (e.g., silicon dioxide) and the second layer can be a high-k dielectric material (e.g., hafnium oxide). In some embodiments, an annealing process may be carried out on the gate dielectric to improve its quality when a high-k dielectric material is used. In some embodiments, the high-k material can be nitridized to improve its aging resistance.

The gate electrode may be deposited over the gate dielectric and can be any standard or proprietary gate structure that may include any number of gate cuts. In some embodiments, the gate electrode includes doped polysilicon, a metal, or a metal alloy. Example suitable metals or metal alloys include aluminum, tungsten, cobalt, molybdenum, ruthenium, titanium, tantalum, copper, and carbides and nitrides thereof. The gate electrode may include, for instance, one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates. Recall the workfunction layers formed around first nanoribbons 238 can be different from the workfunction layers formed around second nanoribbons 240, according to some example embodiments.

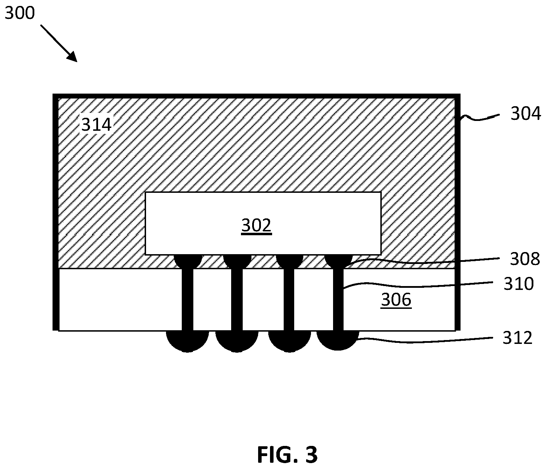

Figure 3 illustrates an example embodiment of a chip package 300, in accordance with an embodiment of the present disclosure. As can be seen, chip package 300 includes one or more dies 302. One or more dies 302 may include at least one integrated circuit having semiconductor devices, such as any of the semiconductor devices disclosed herein. One or more dies 302 may include any other circuitry used to interface with other devices formed on the dies, or other devices connected to chip package 300, in some example configurations.

As can be further seen, chip package 300 includes a housing 304 that is bonded to a package substrate 306. The housing 304 may be any standard or proprietary housing, and may provide, for example, electromagnetic shielding and environmental protection for the components of chip package 300. The one or more dies 302 may be conductively coupled to a package substrate 306 using connections 308, which may be implemented with any number of standard or proprietary connection mechanisms, such as solder bumps, ball grid array (BGA), pins, or wire bonds, to name a few examples. Package substrate 306 may be any standard or proprietary package substrate, but in some cases includes a dielectric material having conductive pathways (e.g., including conductive vias and lines) extending through the dielectric material between the faces of package substrate 306, or between different locations on each face. In some embodiments, package substrate 306 may have a thickness less than 1 millimeter (e.g., between 0.1 millimeters and 0.5 millimeters), although any number of package geometries can be used. Additional conductive contacts 312 may be disposed at an opposite face of package substrate 306 for conductively contacting, for instance, a printed circuit board (PCB). One or more vias 310 extend through a thickness of package substrate 306 to provide conductive pathways between one or more of connections 308 to one or more of contacts 312. Vias 310 are illustrated as single straight columns through package substrate 306 for ease of illustration, although other configurations can be used (e.g., damascene, dual damascene, through-silicon via, or an interconnect structure that meanders through the thickness of substrate 306 to contact one or more intermediate locations therein). In still other embodiments, vias 310 are fabricated by multiple smaller stacked vias, or are staggered at different locations across package substrate 306. In the illustrated embodiment, contacts 312 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 312, to inhibit shorting.

In some embodiments, a mold material 314 may be disposed around the one or more dies 302 included within housing 304 (e.g., between dies 302 and package substrate 306 as an underfill material, as well as between dies 302 and housing 304 as an overfill material). Although the dimensions and qualities of the mold material 314 can vary from one embodiment to the next, in some embodiments, a thickness of mold material 314 is less than 1 millimeter. Example materials that may be used for mold material 314 include epoxy mold materials, as suitable. In some cases, the mold material 314 is thermally conductive, in addition to being electrically insulating.

### Methodology

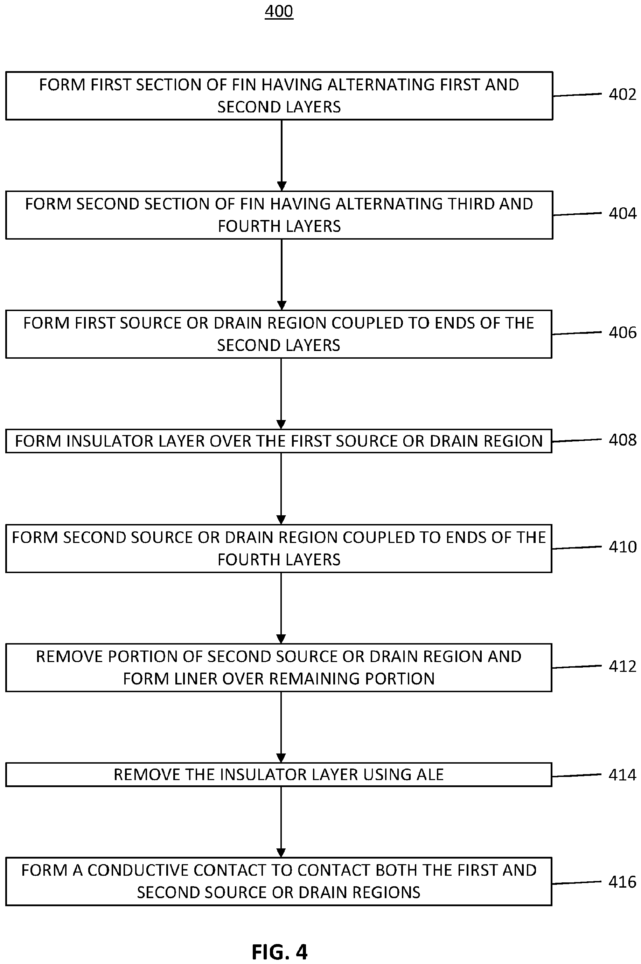

Figure 4 is a flow chart of a method 400 for forming at least a portion of an integrated circuit, according to an embodiment. Various operations of method 400 may be illustrated in Figures 2A - 2L. However, the correlation of the various operations of method 400 to the specific components illustrated in the aforementioned figures is not intended to imply any structural and/or use limitations. Rather, the aforementioned figures provide some example embodiments of method 400. Other operations may be performed before, during, or after any of the operations of method 400. Some of the operations of method 400 may be performed in a different order than the illustrated order.

Method 400 begins with operation 402 where a first section of a fin is formed having alternating first and second layers. The first layers may be sacrificial layers (e.g., comprising SiGe) while the second layers include a semiconductor material (e.g., Si, SiGe, Ge, InP, or GaAs) suitable for use as a nanoribbon channel. The first section may be formed over a substrate. The thickness of each of the first and second layers may be between about 5 nm and about 20 nm or between about 5 nm and about 10 nm. Each of the first and second layers may be deposited using any known material deposition technique, such as CVD, PECVD, PVD, or ALD.

Method 400 continues with operation 404 where a second section of the fin is formed having alternating third and fourth layers. The third layers may be substantially the same as the first layers (sacrificial layers) with substantially the same thickness of the first layers. The fourth layers include a semiconductor material (e.g., Si, SiGe, Ge, InP, or GaAs) suitable for use as a nanoribbon channel and may include substantially the same material composition as the second layers. The thickness of each of the third and fourth layers may be between about 5 nm and about 20 nm or between about 5 nm and about 10 nm. Each of the third and fourth layers may be deposited using any known material deposition technique, such as CVD, PECVD, PVD, or ALD. According to some embodiments, the second fin section is separated from the first fin section by a sacrificial spacer layer that includes the same material composition as any of the first and third layers.

According to some embodiments, once the material layers have been deposited, one or more fins may be defined via an anisotropic etching process, such as RIE, using a patterned mask material to protect the fins from the etch. The fin height may include the alternating material layers of each of the fin sections and a subfin portion formed from the substrate material. In some other embodiments, trenches are first formed in a dielectric material and the alternating material layers of the aforementioned sections are formed within the trenches to form one or more multilayer fins.

Method 400 continues with operation 406 where a first source or drain region is formed that is coupled to ends of the second layers. At least a portion of the first source or drain region may be epitaxially grown from exposed tips of the second layers (e.g., grown from semiconductor seed material), while an internal dielectric spacer material fills a region between the second layers and adjacent to the ends of the second layers. In some embodiments, the first source or drain region includes an epitaxial fill of highly doped semiconductor material.

Method 400 continues with operation 408 where an insulator layer is formed over the first source or drain region. The insulator layer may be formed to provide electrical insulation between stacked epitaxial regions. The insulator layer may be any suitable dielectric material, although in some embodiments the insulator layer is a titanium-based dielectric. The insulator layer may have a thickness between about 5 nm and about 80 nm.

Method 400 continues with operation 410 where a second source or drain region is formed that is coupled to ends of at least the fourth layers. At least a portion of the second source or drain region may be epitaxially grown from exposed tips of the fourth layers (e.g., grown from semiconductor seed material), while an internal dielectric spacer material fills a region between the fourth layers and adjacent to the ends of the fourth layers. In some embodiments, the second source or drain region includes an epitaxial fill of highly doped semiconductor material. The second source or drain region may have an opposite doping type (e.g., n-type vs p-type) compared to the first source or drain region.

Method 400 continues with operation 412 where a portion of the second source or drain region is removed and a liner is formed over the remaining portion of the second source or drain region. According to some embodiments, helmet structures may first be formed to protect side portions of the second source or drain region while a mid-section of the second source or drain region is removed using, for example, an anisotropic etching process. The helmet structures may be deposited using a PVD process to reduce or eliminate the deposition of the helmet structure material on the top surface of the second source or drain region. In another embodiment, ALD in conjunction with an anisotropic etch can be used to form the helmet structure. Once the midsection of the second source or drain region has been removed and the underlying insulator layer has been exposed, a liner may be formed over at least the sidewalls of the remaining portions of the second source or drain region. The liner may be provided to protect the remaining portions of the second source or drain region from subsequent fabrication processes. According to some embodiments, the liner includes a dielectric material that is different from the dielectric material of the insulator layer. The liner may have a lateral thickness between about 1 nm and about 4 nm.

Method 400 continues with operation 414 where the insulator layer is removed using an ALE process. The vapor phase ALE process may be used to remove an entirety (or nearly all, such as more than 95%) of the insulator layer. For example, the insulator layer may be exposed to a vapor containing a metal halide etchant at a temperature between about 100 °C and about 400 °C. Some examples of metal halides include MoCl₅, MoF₆, WF₆, WCl₆, VF₅, or NbFs. The etching process may use either a continuous or pulsed exposure to the metal chloride or fluoride vapor. In the case of pulsed exposure, an alternating exposure profile may be used. For example, an oxidizing agent such as O₂, H₂O₂, or O₃ may be introduced followed by a purge and then introduction of the metal halide etchant followed by another purge, which repeats any number of times in an atomic layer etch sequence. As noted above, portions of the insulator layer may be left within the lower corners of the region previously occupied by the insulator layer.

According to some embodiments, the ALE process leaves behind a conductive layer along at least the top surface of the first source or drain region. The conductive layer may include a metal used in the metal halide etchant, such as Mo, W, V, or Nb. According to some embodiments, the conductive layer is a silicide or germanide of any of the aforementioned metals. The conductive layer may have a thickness between about 0.5 nm and about 2 nm.

Method 400 continues with operation 416 where a conductive contact is formed over the first source or drain region such that the conductive contact contacts both the first source or drain region and the second source or drain region. The conductive contact may include any suitable conductive material, such as Cu, Ru, W, Co, Ti, Mo, or any alloys thereof. Since the insulator layer was fully removed, in some embodiments, the conductive contact has a greater width when contacting the first source or drain region. For example, the conductive contact has a greater width when contacting the first source or drain region compared to its width when contacting the second source or drain region. The conductive contact may have a width between about 5 nm and about 30 nm where it contacts the second source or drain region and may have a width between about 10 nm and about 40 nm where it contacts the first source or drain region. According to some embodiments, a lower contact resistance results from the increased width of the conductive contact across the top surface of the first source or drain region.

### Example System

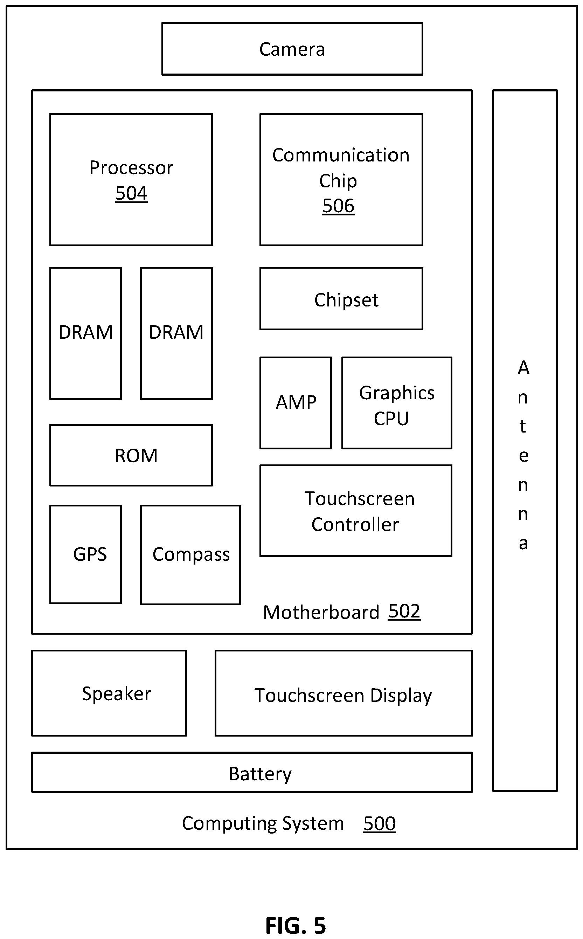

Figure 5 is an example computing system implemented with one or more of the integrated circuit structures as disclosed herein, in accordance with some embodiments of the present disclosure. As can be seen, the computing system 500 houses a motherboard 502. The motherboard 502 may include a number of components, including, but not limited to, a processor 504 and at least one communication chip 506, each of which can be physically and electrically coupled to the motherboard 502, or otherwise integrated therein. As will be appreciated, the motherboard 502 may be, for example, any printed circuit board (PCB), whether a main board, a daughterboard mounted on a main board, or the only board of system 500, etc.

Depending on its applications, computing system 500 may include one or more other components that may or may not be physically and electrically coupled to the motherboard 502. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 500 may include one or more integrated circuit structures or devices configured in accordance with an example embodiment (e.g., a module including an integrated circuit device on a substrate, the substrate having a stacked configuration of semiconductor devices, as variously provided herein). In some embodiments, multiple functions can be integrated into one or more chips (e.g., for instance, note that the communication chip 506 can be part of or otherwise integrated into the processor 504).

The communication chip 506 enables wireless communications for the transfer of data to and from the computing system 500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 506 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 500 may include a plurality of communication chips 506. For instance, a first communication chip 506 may be dedicated to shorter range wireless communications such as Wi-Fi and Bluetooth and a second communication chip 506 may be dedicated to longer range wireless communications such as GPS, EDGE, GPRS, CDMA, WiMAX, LTE, Ev-DO, and others.

The processor 504 of the computing system 500 includes an integrated circuit die packaged within the processor 504. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 506 also may include an integrated circuit die packaged within the communication chip 506. In accordance with some such example embodiments, the integrated circuit die of the communication chip includes one or more semiconductor devices as variously described herein. As will be appreciated in light of this disclosure, note that multi-standard wireless capability may be integrated directly into the processor 504 (e.g., where functionality of any chips 506 is integrated into processor 504, rather than having separate communication chips). Further note that processor 504 may be a chip set having such wireless capability. In short, any number of processor 504 and/or communication chips 506 can be used. Likewise, any one chip or chip set can have multiple functions integrated therein.

In various implementations, the computing system 500 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 500 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a first semiconductor device having one or more first semiconductor bodies extending in a first direction between a first source or drain region and a second source or drain region, and a second semiconductor device having one or more second semiconductor bodies extending in the first direction between a third source or drain region and a fourth source or drain region. The one or more first semiconductor bodies are spaced vertically from the one or more second semiconductor bodies in a second direction different from the first direction. The integrated circuit also includes a conductive contact structure adjacent to at least the second semiconductor device. The conductive contact structure contacts a side surface of the third source or drain region and has a first width at the third source or drain region. The conductive contact structure contacts a top surface of the first source or drain region and has a second width between the third source or drain region and the first source or drain region, the second width being greater than the first width.

Example 2 includes the subject matter of Example 1, wherein the one or more first semiconductor bodies and the one or more second semiconductor bodies comprise nanoribbons including germanium, or silicon, or both germanium and silicon.

Example 3 includes the subject matter of Example 1 or 2, wherein the one or more first semiconductor bodies is n-type silicon and the one or more second semiconductor bodies is p-type silicon.

Example 4 includes the subject matter of any one of Examples 1-3, wherein a vertical distance between the one or more first semiconductor bodies and the one or more second semiconductor bodies is between about 5 nm and about 80 nm.

Example 5 includes the subject matter of any one of Examples 1-4, wherein the second width of the conductive contact structure is substantially the same as a width of the first source or drain region.

Example 6 includes the subject matter of any one of Examples 1-5, wherein the conductive contact structure comprises a continuous body of first material and a conductive layer having a second material, the continuous body extending on or adjacent the side surface of the third source or drain region to the conductive layer, and the conductive layer being directly on the top surface of the first source or drain region.

Example 7 includes the subject matter of Example 6, wherein the first material comprises copper (Cu), ruthenium (Ru), tungsten (W), cobalt (Co), or molybdenum (Mo), and the second material comprises Mo, W, vanadium (V), or niobium (Nb).

Example 8 includes the subject matter of Example 6 or 7, wherein the conductive layer has a thickness between 0.5 nm and 2 nm.

Example 9 includes the subject matter of any one of Examples 6-8, further comprising a spacer structure that extends between the one or more first semiconductor bodies and the one or more second semiconductor bodies in the second direction, wherein a residue of the second material is directly on a portion of a sidewall of the spacer structure.

Example 10 is a printed circuit board comprising the integrated circuit of any one of Examples 1-9.

Example 11 is an electronic device having a chip package comprising one or more dies. At least one of the one or more dies includes a first semiconductor device having one or more first semiconductor nanoribbons extending in a first direction between a first source or drain region and a second source or drain region, and a second semiconductor device having one or more second semiconductor nanoribbons extending in the first direction between a third source or drain region and a fourth source or drain region. The one or more first semiconductor nanoribbons are spaced vertically from the one or more second semiconductor nanoribbons in a second direction different from the first direction. The integrated circuit also includes a conductive contact structure adjacent to at least the second semiconductor device. The conductive contact structure contacts a side surface of the third source or drain region and has a first width at the third source or drain region. The conductive contact structure contacts a top surface of the first source or drain region and has a second width between the third source or drain region and the first source or drain region, the second width being greater than the first width.

Example 12 includes the subject matter of Example 11, wherein the one or more first semiconductor nanoribbons and the one or more second semiconductor nanoribbons comprise germanium, silicon, or any combination thereof.

Example 13 includes the subject matter of Example 11 or 12, wherein the one or more first semiconductor nanoribbons is n-type silicon and the one or more second semiconductor nanoribbons is p-type silicon.

Example 14 includes the subject matter of any one of Examples 11-13, wherein a vertical distance between the one or more first semiconductor nanoribbons and the one or more second semiconductor nanoribbons is between about 5 nm and about 80 nm.

Example 15 includes the subject matter of any one of Examples 11-14, wherein the second width of the conductive contact is substantially the same as a width of the first source or drain region.

Example 16 includes the subject matter of any one of Examples 11-15, wherein the conductive contact comprises a first material and a conductive layer having a second material, the conductive layer being directly on the top surface of the first source or drain region.

Example 17 includes the subject matter of Example 16, wherein the first material comprises copper (Cu), ruthenium (Ru), tungsten (W), cobalt (Co), or molybdenum (Mo), and the second material comprises Mo, W, vanadium (V), or niobium (Nb).

Example 18 includes the subject matter of Example 16 or 17, wherein the conductive layer has a thickness between 0.5 nm and 2 nm.

Example 19 includes the subject matter of any one of Examples 16-18, further comprising a spacer structure that extends between the one or more first semiconductor nanoribbons and the one or more second semiconductor nanoribbons in the second direction, wherein a residue of the second material is directly on a portion of a sidewall of the spacer structure.

Example 20 includes the subject matter of any one of Examples 11-19, further comprising a printed circuit board, wherein the chip package is attached to the printed circuit board.

Example 21 is a method of forming an integrated circuit. The method includes forming a multilayer fin having a first section with first material layers alternating with second material layers, the second material layers comprising a semiconductor material suitable for use as a nanoribbon channel, and a second section over the first section and comprising third material layers alternating with fourth material layers, wherein the fourth material layers comprise a semiconductor material suitable for use as a nanoribbon channel; forming an inner spacer structure around ends of the second and fourth material layers; forming a first source or drain region coupled to the ends of the second material layers; forming a blocking layer over the first source or drain region; forming a second source or drain region coupled to the ends of the fourth material layers and over the blocking layer; removing a portion of the second source or drain region and forming a liner over a remaining portion of the second source or drain region; removing the blocking layer; removing the liner; and forming a conductive contact that contacts at least a side surface of the second source or drain region and a top surface of the first source or drain region.

Example 22 includes the subject matter of Example 21, wherein the first and third material layers comprise silicon and germanium and the second and fourth material layers comprise silicon.

Example 23 includes the subject matter of Example 21 or 22, wherein the second section of the fin is separated from the first section of the fin by a vertical distance between about 5 nm and about 80 nm.

Example 24 includes the subject matter of any one of Examples 21-23, further comprising removing the first and third material layers.

Example 25 includes the subject matter of Example 24, further comprising forming a gate structure around portions of the second material layers and around portions of the fourth material layers.

Example 26 includes the subject matter of any one of Examples 21-25, wherein removing the blocking layer comprises using an atomic layer etch (ALE) process.

Example 27 includes the subject matter of Example 26, wherein the ALE process uses vapor exposure to one of MoCl₅, MoF₆, WF₆, WCl₆, VF₅, or NbF₅.

Example 28 includes the subject matter of Example 26 or 27, wherein removing the blocking layer further comprises forming a layer comprising Mo, W, V, or Nb on a top surface of the first source or drain region, the layer forming a part of the conductive contact.

Example 29 includes the subject matter of any one of Examples 21-28, wherein the liner comprises aluminum and oxygen.

Example 30 includes the subject matter of any one of Examples 21-29, wherein the remaining portion of the second source or drain region has a lateral thickness between about 2 nm and about 8 nm.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first semiconductor device having one or more first semiconductor bodies extending in a first direction between a first source or drain region and a second source or drain region;
a second semiconductor device having one or more second semiconductor bodies extending in the first direction between a third source or drain region and a fourth source or drain region, the one or more first semiconductor bodies spaced vertically from the one or more second semiconductor bodies in a second direction different from the first direction; and
a conductive contact structure adjacent to at least the second semiconductor device, the conductive contact structure contacting a side surface of the third source or drain region and having a first width at the third source or drain region, and the conductive contact structure contacting a top surface of the first source or drain region and having a second width between the third source or drain region and the first source or drain region, the second width being greater than the first width.

2. The integrated circuit of claim 1, wherein the one or more first semiconductor bodies and the one or more second semiconductor bodies comprise nanoribbons including germanium, or silicon, or both germanium and silicon.

3. The integrated circuit of claim 1 or 2, wherein the one or more first semiconductor bodies is n-type silicon and the one or more second semiconductor bodies is p-type silicon.

4. The integrated circuit of any one of claims 1 through 3, wherein a vertical distance between the one or more first semiconductor bodies and the one or more second semiconductor bodies is between about 5 nm and about 80 nm.

5. The integrated circuit of any one of claims 1 through 4, wherein the second width of the conductive contact structure is substantially the same as a width of the first source or drain region.

6. The integrated circuit of any one of claims 1 through 5, wherein the conductive contact structure comprises a continuous body of first material and a conductive layer having a second material, the continuous body extending on or adjacent the side surface of the third source or drain region to the conductive layer, and the conductive layer being directly on the top surface of the first source or drain region.

7. The integrated circuit of claim 6, wherein the first material comprises copper (Cu), ruthenium (Ru), tungsten (W), cobalt (Co), or molybdenum (Mo), and the second material comprises Mo, W, vanadium (V), or niobium (Nb).

8. The integrated circuit of claim 6 or 7, wherein the conductive layer has a thickness between 0.5 nm and 2 nm.

9. The integrated circuit of any one of claims 6 through 8, further comprising a spacer structure that extends between the one or more first semiconductor bodies and the one or more second semiconductor bodies in the second direction, wherein a residue of the second material is directly on a portion of a sidewall of the spacer structure.

10. A printed circuit board comprising the integrated circuit of any one of claims 1 through 9.

11. A method of forming an integrated circuit, comprising:
forming a multilayer fin having a first section with first material layers alternating with second material layers, the second material layers comprising a semiconductor material suitable for use as a nanoribbon channel, and a second section over the first section and comprising third material layers alternating with fourth material layers, wherein the fourth material layers comprise a semiconductor material suitable for use as a nanoribbon channel;
forming an inner spacer structure around ends of the second and fourth material layers;
forming a first source or drain region coupled to the ends of the second material layers;
forming a blocking layer over the first source or drain region;
forming a second source or drain region coupled to the ends of the fourth material layers and over the blocking layer;
removing a portion of the second source or drain region and forming a liner over a remaining portion of the second source or drain region;
removing the blocking layer;
removing the liner; and
forming a conductive contact that contacts at least a side surface of the second source or drain region and a top surface of the first source or drain region.

12. The method of claim 11, further comprising removing the first and third material layers.

13. The method of claim 11 or 12, wherein removing the blocking layer comprises using an atomic layer etch (ALE) process.

14. The method of claim 13, wherein the ALE process uses vapor exposure to one of MoCl₅, MoF₆, WF₆, WCl₆, VF₅, or NbF₅.

15. The method of claim 13 or 14, wherein removing the blocking layer further comprises forming a layer comprising Mo, W, V, or Nb on a top surface of the first source or drain region, the layer forming a part of the conductive contact.
